# EUROPEAN PATENT APPLICATION

(11) **EP 4 286 865 A1**
(43) Date of publication of application: **06.12.2023**
(21) Application number: 22176945.8
(22) Date of filing: 02.06.2022
(51) Int. Cl.: G01R 15/18, G01R 13/02

(54) **SELF-POWERED AC CURRENT DISPLAYING MODULE**

(71) Applicant: HARTING Electric Stiftung & Co. KG, 32339 Espelkamp (DE)
(72) Inventor: MIHAIU, Ilie Mircea, 550018 Sibiu (RO)
(74) Representative: Dennemeyer & Associates S.A.

(57) **Abstract**

Self-powered AC current displaying module (1) for displaying the value of an alternating current, in particular a secondary current exiting a current source (18), in particular a current transformer, the module (1) comprising an electronic circuitry (4) connectable to the current source (18) and supplied by the alternating current, wherein the electronic circuitry (4) comprises a measuring and displaying unit (5) for measuring and displaying a current flowing in said measuring and displaying unit (5) and a reference voltage unit (6) for providing a reference voltage to the measuring and displaying unit (5) and for dividing a circuit current flowing in the electronic circuitry (4) between two branches, wherein one of the branches is configured to power supply at least said measuring and displaying unit (5).

## Description

The present invention relates to a self-powered AC current displaying module for displaying the value of an alternating current, in particular of a secondary current exiting a current source, in particular a current transformer. Also, the present invention relates to a system for measuring and displaying an alternating current comprising said self-powered current displaying module.

The measurement of an alternating current can be carried out in different ways. When dealing with very high currents, the use of current transformers (CTs) could be the best solution. CTs are inductive sensors consisting of a primary coil, a magnetic core, and a secondary coil. Essentially, a high current is transformed to a lower current using a magnetic carrier, thus very high currents can be measured safely and efficiently. In most CTs, the primary coil has very few turns, while the secondary coil has many more turns. This ratio of turns between the primary and secondary coil determines how much the magnitude of the current load is stepped down. The alternating current detected by the primary coil produces a magnetic field in the core, which induces a current in the secondary coil. This current is thus converted to the output of the sensor.

Generally, a current transformer is used to transmit current information signal to a measuring instrument, protective device, or similar apparatus. In particular, in order to display the transmitted current information and in particular to display the value of the current induced in the secondary coil, an analog or digital ammeter or voltmeter is attached to the current transformer. This implies the use of connecting cables between the current transformer and the display system. Also, an additional power source is required to supply for example said display system. However, in some circumstances, this could be inefficient and not cost-effective, especially when a very accurate measurement of the current is not required and an easy manageable measurement and display device is desired.

Examples of the present disclosure seek to address or at least alleviate the above problems.

In a first aspect, there is provided a self-powered AC current displaying module for displaying the value of an alternating current, in particular a secondary current exiting a current source, in particular a current transformer, the module comprising an electronic circuitry connectable to the current source and supplied by the alternating current, wherein the electronic circuitry comprises a measuring and displaying unit for measuring and displaying a current flowing in said measuring and displaying unit and a reference voltage unit for providing a reference voltage to the measuring and displaying unit and for dividing a circuit current flowing in the electronic circuitry between two branches, wherein one of the branches is configured to power supply at least said measuring and displaying unit.

In a second aspect there is provided a system for measuring and displaying an alternating current, the system comprising a current source including an induction module coupable to an electric cable, through which a primary current flows, said induction module being configured to induce a secondary current from said primary current, wherein the primary current is an alternating current, and a self-powered AC current display module according to the first aspect, wherein the current display module is connectable to the current source for measuring and displaying the value of the primary current flowing in the electric cable, the current display module being supplied by the secondary current.

Other aspects and features are defined in the appended claims.

Examples of the disclosure may provide a current displaying module and a corresponding system that can display the value of a measured alternating current flowing through an AC cable without the need of an external power and with the possibility of a remote communication.

Examples of the disclosure will now be described by way of example only with reference to the accompanying drawings, in which like references refer to like parts, and in which:
Figure 1A is a schematic representation of a system according to an example;
Figure 1B is a schematic representation of a self-powered current displaying module according to an example; and
Figure 2 is an electronic circuit of a system and of a self-powered current displaying module according to an example.
Figure 3 is an electronic circuit of a system and of a self-powered current displaying module according to another example.

A self-powered current displaying module is disclosed. In the following description, a number of specific details are presented in order to provide a thorough understanding of the examples of the disclosure. It will be apparent however to a person skilled in the art that these specific details need not be employed in order to practise the examples of the disclosure. Conversely, specific details known to the person skilled in the art are omitted for the purposes of clarity in presenting the examples.

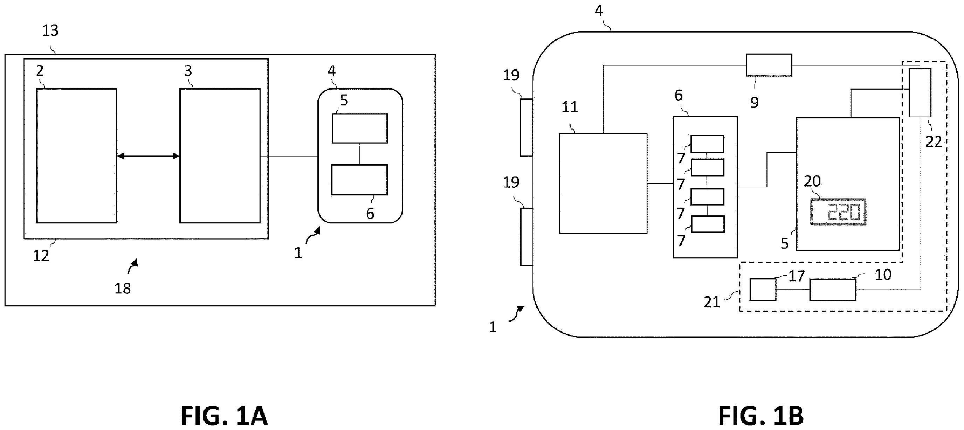

Figure 1A illustrates a schematic representation of a system 13 and a current display module 1 used for measuring and displaying an alternating current exiting a current source 18. In particular, the current source 18 can be a current transformer including an induction module 12 that can be coupled to an electric cable, in particular an AC cable. The induction module 12 comprises a magnetic core 2 and a secondary coil 3 coupled to the magnetic core 2. The induction module 12, in particular the magnetic core 2, is coupled to an electric cable, through which a primary current flows. The induction module 12 is configured to induce a secondary current from the primary current, wherein the primary current is an alternating current. In other words, the magnetic core 2 and the secondary coil 3 are part of a current transformer. In this way, the system 13 and the current display module 1 can offer a measurement of the value current flowing in the electric cable coupled to the induction module 12.

The self-powered current displaying module 1 is connected to the current source 18 and in particular to the induction module 12, and more in particular to the output of the secondary coil 3, and is configured to measure and display the value of the secondary current induced by the induction module 12. As shown in the figure, the self-powered current displaying module 1 comprises an electronic circuitry 4 directly coupled to the secondary coil 3. The electronic circuitry 4 comprises a measuring and displaying unit 5 and a reference voltage unit 6 connected to the measuring and displaying unit 5. The reference voltage unit 6 is part of the electronic circuitry 4 and serves to supply the measuring and displaying unit 5. Accordingly, the measuring and displaying unit 5 does not need an external power supply in order to measure and display the circuit current, i.e. the secondary current. With circuit current is intended the electrical current flowing in the electronic circuitry 4. As it will be explained below, the circuit current can be a direct current as a result of a AC/DC transformation of the alternating current, in particular secondary current exiting the current source 18, i.e. the current transformer. Therefore, the circuit current flowing in the electronic circuitry 4 is directly related to the value of the alternating current exiting the current source 18. It is noted that the measuring and displaying unit 5 directly measure and display the circuit current. However, since the circuit current derives from the secondary current that is a function of the primary current of the current transformer by a proportional factor (due to the structural characteristics of said transformer), the measuring and displaying unit 5 can indirectly measure and displaying the primary current if the proportional factor is known.

In examples, the measuring and displaying unit 5 is integrated in the electronic circuitry. In other words, the measuring and displaying unit 5 is part of the circuit and is therefore connected to the secondary coil 3 of the current transformer without the need of connecting cables. This makes the current displaying module extremely compact and manageable. Therefore, the current displaying module can be easily attached in a removable way to a current transformer when needed. Also, since the electronic circuitry is supplied by the secondary current, there is no need of an external power source.

In examples, the measuring and displaying unit 5 comprises a digital measuring device, in particular a voltmeter. The digital measuring device can be a digital voltmeter 0-200mV with a display screen 20, for example an LCD display screen, for a digital readout. The voltmeter is provided with a shunt resistor to convert current to voltage and display the circuit current (secondary current) minus own supply current. Alternatively, a LED display can be used. However, in this case the measuring accuracy would decrease due to the fact that a LED display requires a higher current value to be powered. As a matter of fact, whereas the power current needed for a LED display can be between 5 mA and 10 mA, the power current needed for a LCD display can be between around 0.35 mA.

In example, the reference voltage unit 6 is integrated in the electronic circuitry 4. In other words, the reference voltage unit 6 is made by one or more electric components that are part of the electronic circuitry 4 connected to the current transformer. It is noted that the reference voltage unit 6 performs two tasks, i.e. providing a voltage reference used to power the measuring and displaying unit 5 and splitting the circuit current between a first branch directed to the input of the measuring and displaying unit 5 and a second branch to assure the current for the reference voltage.

In particular, as schematically shown in figure 1B, the reference voltage unit 6 can comprise a plurality of diodes 7 arranged in series. The series of diodes 7 can maintain a constant DC output voltage regardless of input fluctuations or variation of load current. Also, differently from other voltage regulators, such as Zener diodes, a chain of diodes 7 can be used with small current values. By changing the number of diodes 7 in series, it is possible to change the threshold voltage of the power supply. The threshold voltage is chosen as a function of the power of the digital display of the measuring and displaying unit 5. In particular, the reference voltage unit 6 assures a reference voltage between 3 V and 7.5 V required to power the measuring and displaying unit 5 and divides the current into two branches, a main branch deviating the current to a shunt resistor 14 and a secondary branch assuring a small current between the plurality of diodes 7, in particular about 0.4 mA.

In examples, electronic circuitry 4 comprises a switching element 9 to deviate the circuit current to an input of the measuring and displaying unit 5 if the circuit current exceeds a first threshold current value. In particular, the first threshold current value can be based on the current value (i.e. the maximum current value) consumed by the measuring and displaying unit 5. In particular, the current value consumed by the measuring and displaying unit 5 can be higher than 0.35 mA and lower than 1 mA. As a matter of fact, in order to function, the measuring and displaying unit 5 consumes a small part of the circuit current (secondary current), i.e. the first threshold current value. This is provided to the measuring and displaying unit 5 through the reference voltage unit 6, i.e. through the plurality of diodes 7. The plurality of diodes 7 assures a threshold voltage for powering the measuring and displaying unit 5 but also other elements of the electronic circuitry 4. All these elements are powered from the input of the threshold voltage, and the power current is only function of their characteristics. For example, the digital display (i.e., the measuring and displaying unit 5) requires around 0.35 mA power current, the reference voltage requires around 0.4 mA power current, the Schmitt trigger (described below in the description) requires 0.42 mA. Accordingly, the total current is about between 1.2 mA and 1.5 mA. For these values, the threshold voltage is around 4.2 V. Once the circuit current exceeds the value of the current required to function the measuring and displaying unit 5, the first switching element 9 deviates the current to the input of the measuring and displaying unit 5 to carry out the current measurement. It is noted that the measuring and displaying unit 5 displays the value of the circuit current (the secondary current) subtracting its own supply current, i.e. the first threshold current value (e.g. 1 mA or 0.35 mA).

The switching element 9 can be any electronic component able to deviate the current to the input of the measuring and displaying unit 5. In examples, the switching element 9 comprises a bipolar transistor or a MOSFET. The switching element 9 must have a small input current. Specifically, the switching element 9 can be a Darlington PNP transistor or a P channel MOSFET.

In example, the electronic circuitry 4 comprises a protection unit 21 to protect the measuring and displaying unit 5 from overvoltage. As long as the secondary current is bigger than the nominal current, the protection unit 21 closes the loop of the current transformer, i.e. short circuit the current transformer.

In examples, the voltage divider 22 is configured to assure a threshold voltage lower than, or equal to, the maximum input voltage of the measuring and displaying unit 5, in particular lower than, or equal to, 200 mV.

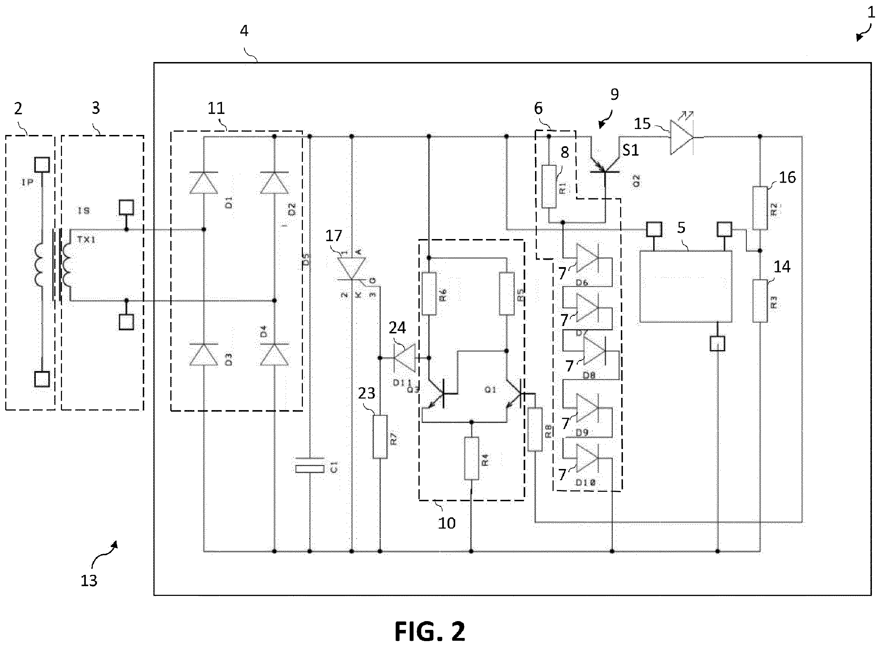

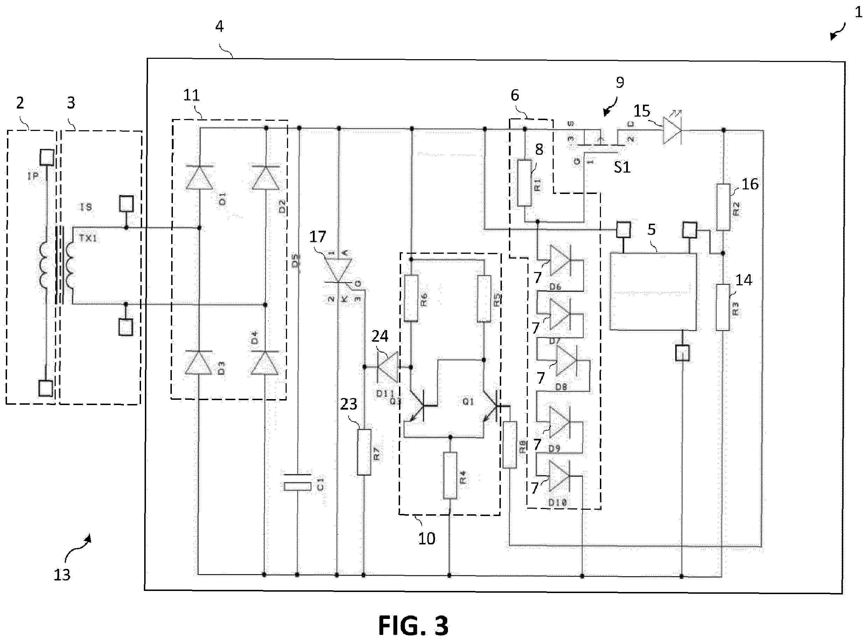

In examples, the protection unit 21 comprises at least a voltage divider 22, a Schmitt trigger 10 and a thyristor element 17. In particular, with reference to figures 2 and 3, the voltage divider 22 comprises a shunt resistor 14 and a supplementary resistor 16. The supplementary resistor 16 is used to assure a dedicated threshold voltage for the Schmitt trigger 10 (for example 1V). The voltage drop to the shunt resistor 14 and the supplementary resistor 16, command the Schmitt trigger 10 to switch on when the output voltage to the shunt resistor 14 is bigger than the maximum voltage of the measuring and displaying unit 5 (200mV).

If the current in shunt of the measuring and displaying unit 5 is greater than the nominal value, the input voltage of the measuring and displaying unit 5 tends to be bigger than the maximum voltage (200mV). In this case, to protect said measuring and displaying unit 5, i.e. the digital voltmeter, the Schmitt trigger 10 is switched on because the applied voltage to the input is greater than the threshold voltage of the Schmitt trigger 10 and the thyristor element 17 short circuit the output of the current transformer and close the loop of the current transformer. As long as the secondary current is bigger than the nominal current, the thyristor element 17 maintains the short circuit to the secondary of the current transformer and protect the measuring and displaying unit 5. In particular, the Schmitt trigger 10 is used to detect the maximum output voltage, due of the maximum secondary output current and to switch on the thyristor element 17, if this maximum value is reached.

In order to indicate the passage of current in the circuitry, the electronic circuitry 4 can comprise a light emitting element 15, e.g. a LED, placed in series to the switching element 9. This is shown in figures 2 and 3 as an example only. However, it is intended that this element is not essential. The light intensity of the light emitting element 15 is proportional to the current value flowing through it so that the higher the current flowing the higher the light intensity of the light emitting element 15. It is however noted that to work properly, the switching element 9 must be in linear region in order not to be saturated. By adding a LED in series with the switching element 9 the drop voltage of the switching element 9 decreases. For example, if the reference voltage is 3V, the output voltage is 1V and the LED drop voltage is 2V, the switching element 9 is saturated and the circuit would not work correctly. In order to use a LED in series with the switching element 9, it is necessary to increase reference voltage. However, the output voltage of the current transformer need to be smaller. It is noted that the maximum admitted reference voltage is 7.5 V in these examples.

In order to convert the alternating current coming from the induction module 12, the electronic circuitry 4 further comprises a rectifying unit 11 connectable between the current source 18, i.e., the induction module 12, and the reference voltage unit 6. Advantageously, the rectifying unit 11 can be in particular a diode bridge. Optionally, a filter capacitor can be connected to the rectifying unit.

The arrangement of the switching element 9, the protection unit 21 and the rectifying unit 11 is schematically shown in figure 1B. In particular, as shown in figure 1B, the alternating current coming from the current source 18, i.e. from the induction module 12, first passes through the rectifying unit 10 and then through the reference voltage unit 6. In this way, the measuring and displaying unit 5 is provided with a DC current. The protection unit 21 comprises at least a voltage divider 22, a Schmitt trigger 10 connected to the output of the voltage divider 22, and a thyristor element 17, connected to the Schmitt trigger 10. The switching element 9 and the protection unit 21 serve to deviate the current to be measured based on the value of the circuit current. If the circuit current is below a certain value (i.e., the first threshold value) no current is measured and displayed because the measuring and displaying unit 5 is not correctly powered. If the circuit current is comprised between two certain values (i.e. between the first and the second threshold value) the switching element 9 is activated and the current is deviated to the input of the measuring and displaying unit 5 and it is measured and displayed. If the circuit current is above a certain value (i.e., the second threshold value), the maximum permitted current is reached and the voltage that drops across the output of the voltage divider 22 overcomes the threshold voltage of the Schmitt trigger 10 and this is switched on. The Schmitt trigger 10 switches the thyristor element 17 on for short circuit the output of the current transformer.

To connect the current display module 1 to the current source 18, the current display module 1 is provided with a connecting junction 19. As shown in figure 1B, the connecting junction 19 can comprise for example two terminals that can be attached to the output terminals of the current source 18.

To visualize the value of the current measured by the current displaying module 1, the measuring and displaying unit 5 can be provided with a dedicated screen 20, in particular an LCD digital display screen. For example, a SP400 blue digital voltmeter can be used as measuring and displaying unit 5 having a power voltage between 3 V and 7.5 V with power current of 350 µA.

As mentioned above, the current source 18 can be a current transformer including the induction module 12 that comprises a magnetic core 2 and a secondary coil 3 coupled to the magnetic core 2. To protect the current transformer and electronic parts in the electronic circuitry 4, the secondary coil 3 is always an output closed circuit.

The current transformer can have a current transformation ratio between 200 A/25 mA and 200 A/1 A. For a current transformer with a larger ratio, such as 200A/5A, the power dissipated to the switching element 9 would be too big..

The power current of the measuring and displaying unit 5 is under 2 mA. To display the current with acceptable accuracy, the current transformer must have a secondary current bigger than 25 mA and smaller than 1 A. For the output current smaller than 25 mA the accuracy decreases because of the own power current. It is however pointed out that current transformers with the secondary current smaller than 25 mA do not exist. For the current transformers with large current, for example 5A, the dissipated power to the switching element 9 increases, for example about 20W for 5A and 4V.

In order to ensure a remote communication of the data provided by the current displaying module 1, the system 1 can further comprise a digital wireless module.

Advantageously, the current displaying module 1 can be a separated device that can be attached to a current source 18 to obtain a measurement of the current value exiting the current source 18. By suitably connecting the electronic circuitry 4 to the current source 18, i.e. to a portion of the current source 18, the measurement and displaying unit 5 can offer an information regarding the value of the alternating current exiting the current source 18 without the need of an external power source. Accordingly, the current display module 1 can comprise a connecting junction 19 to connect the electronic circuitry 4 to the current source 18. For example, the connecting junction 19 can comprise one or more connecting terminals that can be directly attached to the output terminal of the current source 18. In case the current source 18 is a current transformer, the connecting terminals can be attached to the secondary coil 3 of the current transformer. In a different configuration, the connecting junction 19 can include at least a portion of the secondary coil 3 and/or at least a portion of the magnetic core 2 of the current transformer, so that the current displaying module 1 can be easily and quickly used to combine the at least portion of the secondary coil 3 and/or the at least portion of the magnetic core 2 with a remaining portion of the secondary coil 3 and/or of the magnetic core 2, respectively, and can be laid around an AC cable to have a measurement of the current flowing in said cable.

Figures 2 and 3 illustrate a circuitry configuration for the system 13 and the current displaying module 1.

The system 1 comprises a magnetic core 2 coupable to an electric cable, through which a primary current (IP) flows. A secondary current (IS) is induced by the primary current (IP) on a secondary coil 3 coupled to the magnetic core 2. An electronic circuitry 4 forming the current displaying module 1 is connected to the secondary coil 3. The secondary coil 3 is directly connected to a rectifying unit 11 formed by a diode bridge of four diodes (D1-D4). The diode bridge 1 is then connected to the reference voltage unit 6 that is inserted between the rectifying unit 11 and the measuring and displaying unit 5. The reference voltage unit 6 comprises a plurality of diodes 7 connected in series. According to the figure, the reference voltage unit 6 comprises five diodes (D6-D10). However, a different number of diodes 7 (less than five or more than five) can be chosen to change the threshold voltage of the power supply. Also, the reference voltage unit 6 comprises at least a first resistor (R1) 8. A switching element (S1) 9 is used to deviate the circuit current based on the value of the secondary current. According to figure 2, the switching element 9 is a bipolar Darlington PNP transistor. It is however clear that other type of switching element can be take into account (switching element with low input current), for example P MOSFET. The switching transistor must have a small base current (for bipolar transistors) or near zero gate current (for P MOSFET). For example, figure 3 shows a circuit similar to that of figure 2, whereas the switching element 9 is a P-MOS transistor. As mentioned above, the number of diodes 7 can be different based on the circuit configuration. For example, by using a P-MOSFET as switching element 9, the number of diodes 7 can be lower (e.g. three or four) than the number of diodes 7 (e.g. five) when using a P Darlington PNP transistor. This is because the threshold voltage of the MOSFET is bigger that the threshold voltage of the P Darlington PNP transistor.

The output of the current transformer is rectified by a diode bridge (D1-D4) and then applied to a circuit consisting of a series of diodes (D6-D10) and a first resistor (R1). The series diodes voltage assures the threshold voltage required to power the measuring and displaying unit 5 (i.e. a digital milli-voltmeter) that consumes around 1.5 mA or less. If the circuit current exceeds a determined value, e.g. if the current at the first resistor R1 exceeds for example 0.5 mA, the switching element (S1) is activated and the rest of the circuit current is deviated to the input of the measuring and displaying unit 5. The measuring and displaying unit 5 displays the circuit current minus its own supply current. As it is known, classic current transformers have a current transformation ratio of 200 A / 25 mA or higher. Primary currents that are less than 16 A cannot be viewed because the electronic part is not powered. Similarly, for current transformers having a current transformation ratio of 200 A / 500 mA, primary currents that are less than 0.8 A cannot be viewed because also in this case the electronic part is not powered.

The current displaying module 1 efficiently works if the nominal secondary current is higher than 25 mA and lower than 1 A. For current smaller than 25 mA, measurement errors will occur for low current values. The electronic part requires for example a maximum 2 mA supply current, and the display would shows the measured current minus 2 mA. If the nominal secondary current is bigger than 1 A, the dissipated power of the switching element 9 increases, for example 4 W, if the current is 1 A and the voltage drop is 4 V.

To protect the measuring and displaying unit 5 from overvoltage, a supplementary resistor 16 (R2) must be added to the main output of the switching element 9. The voltage drop of the supplementary resistor 16 (R2) and the shunt resistor 14 (R3), i.e., of the voltage divider 22, is used to control the Schmitt trigger 10. If the output current is greater than the nominal value, the drop voltage of the series resistances (R2+R3) is bigger than the threshold voltage of the Schmitt trigger 10 (e.g., about 1 Volt) and this trigger 10 is activated and the current (i.e., the secondary current) is deviated to the thyristor element 17 to close the loop of the current transformer, to protect input of the digital display to overvoltage. The maximum input voltage for measuring and displaying unit 5 is 200mV. The Schmitt trigger 10 switches the thyristor element 17 on and shortcircuits the output of the current transformer, to protect the measuring and displaying unit 5. The Schmitt trigger 10 comprises for example two bipolar transistors (Q1 and Q3) and three resistors (R4, R5, R6).

In examples, the gate of the thyristor element 17 is connected to a second resistor (R7) 23 so that the thyristor element 17 is off if the Schmitt trigger 10 is not switched on. Also, an additional diode (D11) 24 is placed between the output of the Schmitt trigger 10 and the gate of the thyristor element 17 to assure a correct direction of the gate current. Furthermore, the voltage required to switch on the Schmitt trigger 10 is around 1 V when the secondary current has the nominal value. If the secondary current is bigger than the nominal current, the Schmitt trigger 10 is switched on and the thyristor element 17 is configured to short circuit the output of the current transformer.

Advantageously, since the electronic circuitry 4 is supplied by the secondary current induced in the secondary coil 3, the measuring and displaying unit 5 can operate without supply voltage. Also, this current displaying module 1 can be coupled to a current transformer as an additional module when it is necessary to obtain a measurement and a display of the value of the alternating current flowing in a AC cable. It is noted that current displaying module 1 can be attached to the current transformer, without its own power supply since it is powered by a small part of the secondary current of the current transformer. In other words, a small part of the secondary current is used to power the electronic part of the current displaying module 1. The measuring and displaying unit 5 and the rest of the electronic components of the electronic circuit 4 are selected to obtain the minimum power current for all electronic part. On the other hand, the voltage at the output of the current transformer must be low. The measuring and displaying unit 5 requires minimum 3V and 0.35mA for own power.

Although a variety of techniques and examples of such techniques have been described herein, these are provided by way of example only and many variations and modifications on such examples will be apparent to the skilled person and fall within the spirit and scope of the present invention, which is defined by the appended claims and their equivalents.

### Reference Signs

- 1: Current displaying module
- 2: Magnetic core
- 3: Secondary coil
- 4: Electronic circuitry
- 5: Measuring and displaying unit
- 6: Reference voltage unit
- 7: Diode
- 8: First resistor
- 9: Switching element
- 10: Schmitt trigger
- 11: Rectifying unit
- 12: Induction module
- 13: System
- 14: Shunt resistor
- 15: Light emitting element
- 16: Supplementary resistor
- 17: Thyristor
- 18: Current source
- 19: Connecting junctions
- 20: Screen
- 21: Protection unit
- 22: Voltage divider
- 23: Second resistor
- 24: Additional diode

## Claims

1. Self-powered AC current displaying module (1) for displaying the value of an alternating current, in particular a secondary current exiting a current source (18), in particular a current transformer, the module (1) comprising:
an electronic circuitry (4) connectable to the current source (18) and supplied by the alternating current,
wherein the electronic circuitry (4) comprises a measuring and displaying unit (5) for measuring and displaying a current flowing in said measuring and displaying unit (5) and a reference voltage unit (6) for providing a reference voltage to the measuring and displaying unit (5) and for dividing a circuit current flowing in the electronic circuitry (4) between two branches, wherein one of the branches is configured to power supply at least said measuring and displaying unit (5).

2. Current displaying module (1) according to claim 1, wherein
a. the measuring and displaying unit (5) is integrated in the electronic circuitry (4); and/or
b. the measuring and displaying unit (5) comprises a digital measuring device, in particular a voltmeter.

3. Current displaying module (1) according to any one of the preceding claims, wherein the reference voltage unit (6) is integrated in the electronic circuitry (4).

4. Current displaying module (1) according to any one of the preceding claims, wherein the reference voltage unit (6) comprises a plurality of diodes (7) arranged in series to assure a reference voltage to power the measuring and displaying unit (5).

5. Current displaying module (1) according to any one of the preceding claims, wherein the electronic circuitry (4) comprises a switching element (9) to deviate the circuit current to an input of the measuring and displaying unit (5) if the circuit current exceeds a first threshold current value.

6. Current displaying module (1) according to claim 5, wherein
a. the first threshold current value is based on the current value consumed by the measuring and displaying unit (5), wherein in particular the current value consumed by the measuring and displaying unit (5) is higher than 0.35 mA and lower than 1mA; and/or
b. the switching element (9) comprises a bipolar transistor or a MOSFET, in particular a Darlington PNP transistor, or a P channel MOSFET.

7. Current displaying module (1) according to any one of the preceding claims, wherein the electronic circuitry (4) comprises a protection unit (21) to protect the measuring and displaying unit (5) from overvoltage.

8. Current displaying module (1) according to claim 7, wherein
the protection unit (21) comprises at least a voltage divider (22), a Schmitt trigger (10) and a thyristor element (17).

9. Current displaying module (1) according to claim 8, wherein the voltage divider (22) is configured to assure a threshold voltage lower than, or equal to, the maximum input voltage of the measuring and displaying unit (5), in particular lower than, or equal to, 200 mV.

10. Current displaying module (1) according to claim 8 or 9, wherein
a. the gate of the thyristor element (17) is connected to a second resistor (23) so that the thyristor element (17) is off if the Schmitt trigger (10) is not switched on; and/or
b. an additional diode (24) is placed between the output of the Schmitt trigger (10) and the gate of the thyristor element (17) to assure a correct direction of the gate current; and/or
c. the voltage required to switch on the Schmitt trigger (10) is 1 V when the secondary current has the nominal value; and/or
d. if the secondary current is bigger than the nominal current, the Schmitt trigger (10) is switched on and the thyristor element (17) is configured to short circuit the output of the current transformer.

11. Current displaying module (1) according to any one of the preceding claims, wherein the electronic circuitry (4) further comprises a rectifying unit (11) connectable between the current source (18) and the reference voltage unit (6), wherein the rectifying unit (9) is in particular a diode bridge.

12. System (13) for measuring and displaying an alternating current, the system (13) comprising:
a current source (18) including an induction module (12) coupable to an electric cable, through which a primary current flows, said induction module (12) being configured to induce a secondary current from said primary current, wherein the primary current is an alternating current; and
a self-powered AC current display module (1) according to any one of claims 1 to 11, wherein
the current display module (1) is connectable to the current source (18) for measuring and
displaying the value of the primary current flowing in the electric cable, the current display module (1) being supplied by the secondary current.

13. System (13) according to claim 12, wherein the induction module (12) comprises a magnetic core (2) and a secondary coil (3) coupled to the magnetic core (2), wherein the secondary coil (3) is an output closed circuit.

14. System (13) according to any one of claims 12 to 13, wherein the current transformer has a current transformation ratio between 200 A/25 mA and 200 A/1A.

15. System (13) according to any one of claims 12 to 14, further comprising a digital wireless module for remote communications.
